Europäisches Patentamt

European Patent Office

Office européen des brevets

(19)

(11) Veröffentlichungsnummer: **0 003 138**
A1

(12)

# EUROPÄISCHE PATENTANMELDUNG

(21) Anmeldenummer: 79100093.8

(22) Anmeldetag: 12.01.79

(51) Int. Cl.²: **H 03 F 1/34**
**H 04 B 3/36**

(30) Priorität: 13.01.78 DE 2801484

(43) Veröffentlichungstag der Anmeldung:
25.07.79 Patentblatt 79/15

(84) Benannte Vertragsstaaten:
DE FR GB IT NL SE

(71) Anmelder: SIEMENS AKTIENGESELLSCHAFT Berlin
und München
Postfach 261
D-8000 München 22(DE)

(72) Erfinder: Hübner, Franz-Richard
Blaichacher Strasse 6
D-8000 München 71(DE)

(72) Erfinder: Musil, Gerhard
Ludwig-Braille-Strasse 8
D-8000 München 70(DE)

(72) Erfinder: Koppehele, Frithjof
Ludwig-Braille-Strasse 1
D-8000 München 70(DE)

(54) Breitbandverstärker mit einem Verstärkerteil und einem Gegenkopplungsteil.

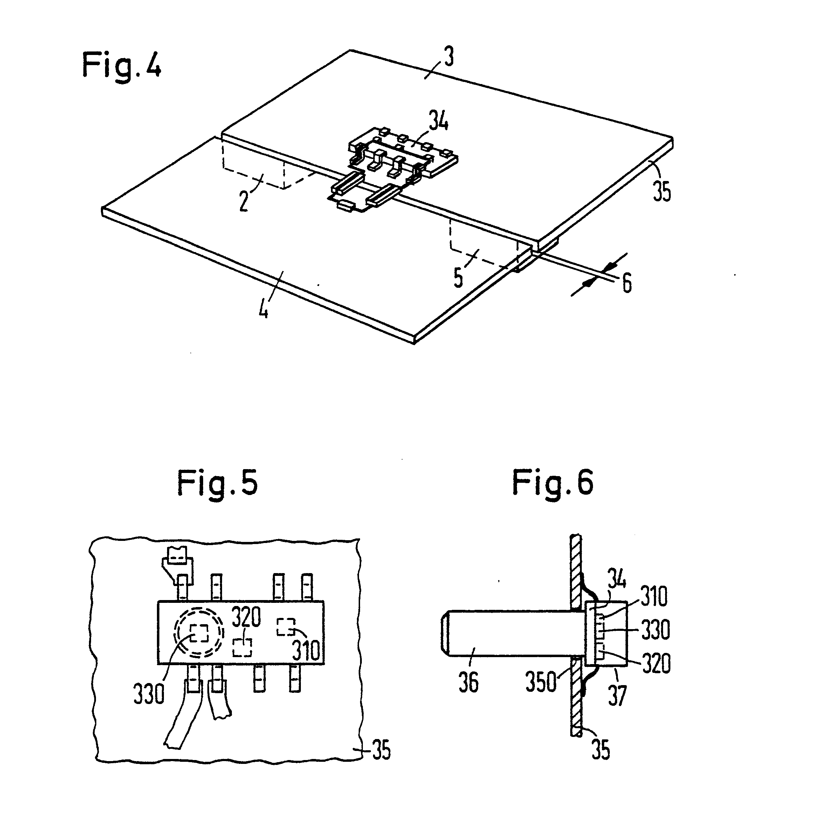

(57) Die Erfindung bezieht sich auf einen Breitbandverstärker mit einem drei Transistorstufen enthaltenden Verstärkerteil (3) und einem Gegenkopplungsteil (4). Bei gegengekoppelten Breitbandverstärken ergeben sich günstige Verstärkereigenschaften, wenn die Schleifenverstärkung große Werte annimmt. Die Erfindung sieht hierzu eine Kettenschaltung von Emitter-, Kollektor- und Emitterstufe (31, 32, 33) im Verstärkerteil (3), einen Zwischenträger (34) für gehäuselose Halbleiter und eine Anordnung der Übertrager (2, 5) auf einer Schichtschaltung vor. Zusätzlich kann der Träger auf der den Halbleitern gegenüberliegenden Seite einen Kühlkörper tragen. Ein erfindungsgemäßer Breitbandverstärker ist insbesondere für den Einsatz in Übertragungseinrichtungen der Trägerfrequenztechnik geeignet (Fig. 4).

Fig.4

EP 0 003 138 A1

0003138

SIEMENS AKTIENGESELLSCHAFT    Unser Zeichen
Berlin und München           VPA 78 P 6503 BRD

Breitbandverstärker mit einem Verstärkerteil und einem
Gegenkopplungsteil

In Nachrichten-Weitverkehrskabelnetzen werden in bestimmten Abständen Verstärker benötigt, die die Kabeldämpfung ausgleichen. Je größer die Bandbreite des Systems ist, desto geringer ist der Abstand zwischen den einzelnen Verstärkern. Die Verstärkungseigenschaften müssen zeitlich sehr konstant sein, d.h. Alterungseinflüsse der Bauelemente dürfen sich praktisch nicht bemerkbar machen. Die Temperaturabhängigkeit der Verstärkung muß ebenfalls eng toleriert sein. Ferner dürfen die - prinzipiell in jedem Verstärkungsmechanismus mit bewegten Ladungsträgern auftretenden - Störgeräusche bestimmte Grenzwerte nicht überschreiten. Bei Übertragungsgeräten für analoge Nachrichten addieren sich die Störgeräusche der einzelnen Verstärker. Je größer die Zahl der Verstärker für eine bestimmte Entfernung ist - d.h. je breitbandiger das Signal ist - desto kleiner müssen die Geräuschbeiträge der einzelnen Leitungsverstärker sein.

Wd 1 Bri / 12.1.1978

Durch Anwendung von Gegenkopplungen kann man sowohl die Störgeräusche verkleinern, als auch die Verstärkungsstabilität gegenüber Schwankungen der Eigenschaften der Verstärkungselemente erhöhen. Außerdem kann ein entsprechend gegengekoppelter Verstärker in seinem Ein- und Ausgangswiderstand relativ verlustarm an den Wellenwiderstand der Leitung angepaßt werden.

Die Erfindung bezieht sich auf einen Breitbandverstärker, vorzugsweise Leitungsverstärker der Trägerfrequenztechnik, mit einem eine Kettenschaltung von drei Transistorstufen enthaltenden Verstärkerteil und einem zwischen dem Ausgang und dem Eingang des Verstärkerteiles angeordneten Gegenkopplungsteil, wobei die in der Kettenschaltung erste und die letzte Transistorstufe als Emitterstufe geschaltet sind.

Ein derartiger Breitbandverstärker ist beispielsweise aus F.Koppehele und P.Kußmaul: "TF-Unterflurverstärker V300 bis V10 800", Siemens-Zeitschrift 48 (1974), Beiheft "Nachrichten-Übertragungstechnik", Seiten 102 bis 105 bekannt. Bei dem bekannten Breitbandverstärker enthält der aktive Verstärkerteil drei in Emitterschaltung betriebene Transistoren. Der passive Verstärkerteil besteht aus einem Gegenkopplungsnetzwerk und zwei Verzweigungsschaltungen, die als Brückenübertrager ausgebildet sind. Die Ein- und Ausgangsübertrager sind nicht auf der Schichtschaltung gehaltert.

Um eine genügend große Gegenkopplung zu erzielen, ist für eine ausreichend geringe Laufzeit innerhalb der Gegenkopplungsschleife gesorgt.

Die Netzwerke des Verstärkers sind in Dünnschicht-Hybridtechnik aufgebaut. Die Transistoren sind in hermetisch dichte Einzelgehäuse eingebaut und in Bohrungen des Substrats eingesetzt. Auf diese Weise wird die Gegenkopplungsschleife relativ kurz gehalten und eine hohe Betriebszuverlässigkeit erzielt.

Aus der Druckschrift E.Braun und F.Koppehele: "Ein Verstärker für 10 800 Fernsprechkanäle", Siemens-Zeitschrift 44 (1970), Heft 4, Seiten 167 bis 169 ist ein Verstärker bekannt, der aus einem aktiven Teil mit den Transistoren und aus einem Gegenkopplungsnetzwerk besteht. Beide sind am Ein- und Ausgang mit Übertragern verbunden und bilden so den eigentlichen Leitungsverstärker. Die Phasendrehung des Übertragungsmaßes in der Gegenkopplungsschleife wird im interessierenden Frequenzbereich nicht nur durch die Transistoren, sondern auch durch die geometrische Länge der Schleife bestimmt. Sie ist klein gegen die Wellenlänge und beträgt nur wenige Zentimeter. Zu diesem Zweck sind der Verstärker und das Gegenkopplungsnetzwerk als Schichtschaltung aufgebaut.

Aufgabe der Erfindung ist es, einen Breitbandverstärker der vorstehend näher bezeichneten Art derart auszubilden, daß sich ein noch weiter vergrößertes Gegenkopplungsmaß erzielen läßt und zugleich ein für die Fertigung günstiger Aufbau ergibt. Insbesondere sollen sich auch für Abgleich und/oder Prüfung möglichst günstige Verhältnisse ergeben.

Man kann die Transistoren des aktiven Verstärkerteiles als gehäuselose Halbleiter-Chips ausbilden und diese unmittelbar auf eine Schichtschaltung des Verstärkerteiles aufbringen, so daß sich eine besonders geringe elektronische Laufzeit im Verstärkerteil ergibt.

Gemäß der Erfindung wird der Breitbandverstärker derart ausgebildet, daß die zwischen den Emitterstufen gelege-

0003138

ne Transistorstufe in Kollektorschaltung geschaltet ist, und daß der Gegenkopplungsteil zwischen dem Kollektor des Transistors der letzten Verstärkerstufe und dem Emitter des Transistors der ersten Transistorstufe angeordnet ist, und daß die Transistoren als gehäuselose Halbleiter ausgebildet und auf einem gemeinsamen Träger angeordnet sind, und daß dem Träger benachbart der Gegenkopplungsteil angeordnet ist, und daß der Eingangsübertrager und der Ausgangsübertrager auf einer einen hochfrequenzwirksamen Teil des Verstärkers enthaltenden Schichtschaltung angeordnet sind.

Durch diese Maßnahmen ergibt sich in vorteilhafter Weise ein leicht prüfbarer Breitbandverstärker, der sehr geringe Laufzeiten hat und bei dem zugleich sichergestellt ist, daß sich die Transistoren leicht prüfen und handhaben lassen.

Weitere vorteilhafte Ausgestaltungen der Erfindung ergeben sich aus den Unteransprüchen.

Die Erfindung wird anhand der in den Fig.1 bis 6 dargestellten Ausführungsbeispiele näher erläutert.

Es zeigen:

Fig.1 einen Breitbandverstärker mit Verstärkerteil und Gegenkopplungsteil,

Fig.2 für einen Breitbandverstärker nach Fig.1 die Abhängigkeit der Schleifenverstärkung von der Länge des Weges über den Verstärker- und den Gegenkopplungsteil,

Fig.3 für eine Emitterstufe die Abhängigkeit der elektronischen Signallaufzeit von der Induktivität der Emitterzuleitung,

Fig.4 den räumlichen Aufbau eines Verstärkers nach

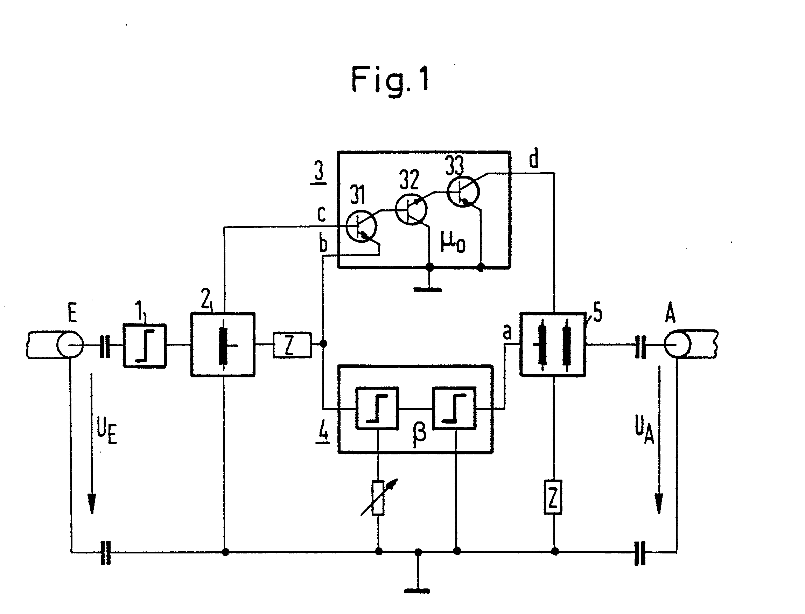

Fig.1 und

Fig.5 und 6 die Ausbildung des die Transistoren
tragenden Trägers.

In Fig.1 ist der Aufbau eines Leitungsverstärkers dargestellt, bei dem die Gegenkopplung über alle Verstärkerstufen verläuft. Bei dem "über alles" gegengekoppelten
Leitungsverstärker ist der Verstärkereingang E ebenso
wie der Verstärkerausgang A auf den Wellenwiderstand
des Kabels (Z=75 Ω) angepaßt. Die Anordnung besteht aus
folgenden Baugruppen:

Vorentzerrer 1, aktiver Teil 3 mit dem Übertragungsfaktor $\mu_o$, passiver Teil 4 mit dem Übertragungsfaktor ß,
Eingangsübertrager 2 und Ausgangsübertrager 5. Die beiden Übertrager 2 und 5 verbinden den aktiven und den
passiven Teil 3 bzw. 4 des Breitbandverstärkers und sind
damit Bestandteil des Gegenkopplungskreises. Die Anordnung erlaubt es, den Verstärkereingang E und den Verstärkerausgang A an den Wellenwiderstand Z des Kabels
verlustarm anzupassen.

Der Übertragungsfaktor, d.h. das Verhältnis von Ausgangsspannung $U_A$ zur Eingangsspannung $U_E$ ergibt sich zu:

$$\frac{U_A}{U_E} = \frac{\mu_o}{1-\mu_o \beta} \cdot k_1 \cdot k_2 \cdot e^{a_v} \tag{1}$$

$k_1$ bzw. $k_2$ sind Übertragungsfaktoren des Eingangs- bzw.
Ausgangsübertragers. $a_v$ ist die Dämpfung des Vorentzerrers.

Die Größe $\mu_o\beta$ bezeichnet man im allgemeinen als Schleifenverstärkung. Es ist erwünscht, sie möglichst groß einzustellen, dann wird der Übertragungsfaktor weitgehend unabhängig von $\mu$. In diesem Fall gilt:

$$\frac{U_A}{U_E} \approx \frac{1}{\beta} \cdot k_1 \cdot k_2 \cdot e^{a_v} \qquad (2)$$

Ferner kann durch die Gegenkopplung erreicht werden, daß sich die durch Nichtlinearitäten verursachten Störgeräusche um den Faktor K

$$K \approx \frac{1}{1-\mu_o\beta} \qquad (3)$$

verkleinern.

Mit wachsender Bandbreite $B_N$ eines Verstärkers sind der Größe $\mu_o\beta$ jedoch physikalische Grenzen gesetzt.

Die maximale Größe der "Gegenkopplung über alles" ist im wesentlichen abhängig von:

a) der Bandbreite der Transistoren,
b) dem Schaltungsaufbau,
c) der Laufzeit der Ladungsträger in den Transistoren und
d) der Laufzeit des Signals im Gegenkopplungskreis.

Es ist bekannt, daß das Verstärkungsbandbreitenprodukt einer Emitterstufe größer als das der Basis- oder Kollektorstufe ist. Aus diesem Grund werden die Transistoren für derartige Verstärker häufig in der Emitterschaltung betrieben. Bei dieser Betriebsart ergibt sich jedoch eine relativ große elektronische Laufzeit in den einzelnen Transistorstufen.

Die beim Breitbandverstärker nach Fig.1 zwischen den Emitterstufen 31 und 33 angeordnete Kollektorstufe hat dagegen eine vernachlässigbare elektronische Laufzeit. Das an sich etwas ungünstigere Breitbandverhalten der Kollektorstufe wird zweckmäßigerweise durch Eigengegenkopplungen verbessert.

Überlegungen im Rahmen der Erfindung haben ergeben, daß der maximal möglichen Gegenkopplung bei Verwendung geeigneter Transistoren in Verbindung mit Schichtschaltungen nicht so sehr durch die bei hohen Frequenzen abnehmende Verstärkung der Transistoren als vielmehr durch die Zeit, die das Signal zum Durchlaufen des Schleifenweges a - b - c - d - a benötigt, physikalische Grenzen gesetzt sind. Diese Zeit setzt sich aus zwei Anteilen zusammen:

a) Signallaufzeit, die im wesentlichen durch die physikalisch-räumliche Ausdehnung des Gegenkopplungskreises bedingt ist,

b) durch die elektronische Signallaufzeit $t_{02}$ innerhalb der Transistoren.

Um die gewünschte Gegenkopplung über den Gegenkopplungskreis zu erzielen, wird der Gegenkopplungskreis zwischen den Kollektor des Endstufentransistors 33 und den Emitter des Eingangsstufentransistors 31 gelegt, derart, daß die erste Verstärkerstufe für die Verstärkung im Schleifenweg als Basisstufe wirkt. Für einen absolut-stabilen Basisbandverstärker ergibt sich

$$\frac{1}{|\beta_o\beta|} \sim \left[ l_{GK} \cdot \alpha t_{01} + t_{02} \right]^2 \qquad (4)$$

$l_{GK}$ = Länge des Weges a - b - c - d - a

$\alpha t_{o1}$ = Signallaufzeit je Längeneinheit.

Hierbei ist vorausgesetzt, daß die Bandbreite der Transistoren wenigstens das Zehnfache der Nutzbandbreite ist.

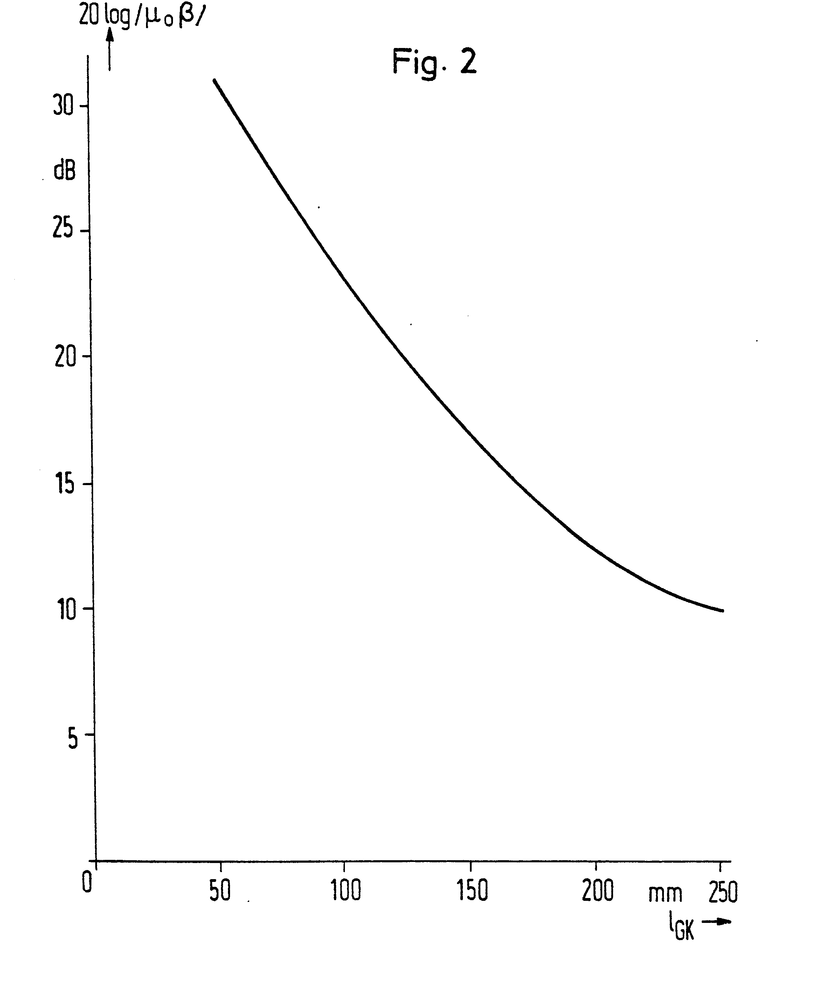

Als Beispiel ist in Fig.2 für einen Verstärker mit 60 MHz Nutzbandbreite der Zusammenhang nach Gleichung (4) dargestellt für den Fall, daß die elektronische Signallaufzeit $t_{02}$ in den Transistoren 0,66 nsec beträgt.

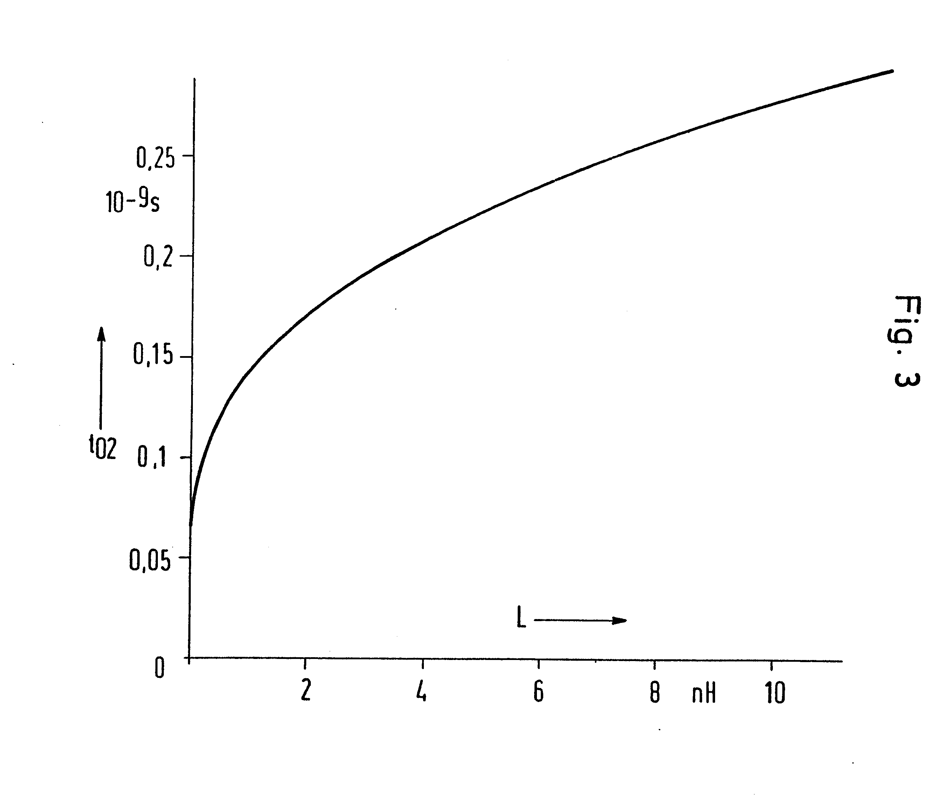

Fig.3 zeigt den typischen Verlauf der elektronischen Laufzeit $t_{02}$ eines Vorstufentransistors in Emitterschaltung abhängig von der Emitterinduktivität L. Insbesondere bei kleinen Werten von L steigt die Laufzeit $t_{02}$ mit wachsendem L steil an. Während man bei Halbleiterbauteilen in hermetisch dichten Gehäusen praktisch keine Werte unter 3 nH entsprechend einer Emitterzuleitung von etwa 2 mm Länge erreichen kann, läßt sich die Laufzeit bei den gehäuselosen Halbleiter-Chips etwa halbieren.

Fig.4 zeigt den Aufbau eines Verstärkers nach Fig.1, bei dem die Signallaufzeit $t_{01}$ und die elektronische Signallaufzeit $t_{02}$ besonders kleine Werte annehmen. Konstruktive Ausbildung der Schichtschaltungen und ihrer Anordnung in einem Gehäuse sind im Hinblick auf kürzeste Gegenkopplungslänge vorgenommen.

Der aktive Teil 3 und das Gegenkopplungsnetzwerk 4 sind jeweils als Schichtschaltung ausgebildet. Das Substrat hat jeweils plattenförmige Gestalt und besteht vorzugsweise aus Keramik. Es können jedoch auch andere HF-geeignete Materialien verwendet werden. Beide Platten sind so in ein und derselben Ebene nebeneinander liegend angeordnet, daß sie nur durch einen schmalen Luftspalt 6 voneinander getrennt sind. Anstelle der beiden Platten kann auch eine gemeinsame Platte treten.

Die Übertrager 2 und 5 sind für den unmittelbaren Einbau in Schichtschaltungen geeignete Breitbandübertrager. Ein bevorzugter, als Schalenkernübertrager ausgebildeter Breitbandübertrager dieser Art, der bei geringen Abmessungen und kleinem Gewicht eine große Bandbreite, kleine Verluste und eine hohe elektrische Gleichmäßigkeit aufweist, geht aus der DE-OS 2 409 881 hervor.

Die Übertrager 2 und 5 sind fest mit dem Substrat der Schichtschaltung des aktiven Teils 3 verbunden. Sie sind an dem Rand des Verstärkerteiles angeordnet, der an den Gegenkopplungsteil grenzt. Eine derartige unmittelbare Anordnung der Übertrager 2 und 5 auf dem aktiven Teil ist mit einer guten Reproduzierbarkeit der elektrischen Eigenschaften verbunden, da die Verbindungsleitungen immer die gleiche Lage und Länge besitzen. Ferner ergeben sich eine Verkürzung des Gegenkopplungsweges. Der aktive Teil mit den Übertragern 2 und 5 bildet zudem eine mechanische und leicht prüfbare Einheit.

Die Übertrager 2 und 5 sind fest auf der Unterseite des Dünnfilmsubstrats des aktiven Teiles 3 angebracht. Auf der Oberseite des Dünnfilmsubstrats ist etwa in der Mitte zwischen den beiden Übertragern 2 und 5 und ebenfalls am Rand des Verstärkerteiles der plattenförmige Träger 34 mit den Halbleitersystemen angeordnet.

Der aktive Teil ist dabei bis auf etwa 0,5 mm an den passiven Teil herangebracht und es ergibt sich ein optimales Ergebnis hinsichtlich einer möglichst geringen Länge des Gegenkopplungsweges $l_{GK}$ einerseits und einer möglichst geringen Verfälschung der Meßergebnisse durch parasitäre Kapazitäten beim Prüfen des Verstärkers andererseits.

0003138

Schädliche Verkopplungen zwischen aktivem Teil 3 und Gegenkopplungsnetzwerk 4 sind so gering, daß hierzu keine besondere Abschirmung nötig ist.

Weitere Einzelheiten des als Zwischenträger dienenden Trägers 34 gehen aus den Fig.5 und 6 hervor. Die Transistoren 310, 320 und 330 sind entsprechend vorgegebenen Parametern ausgesuchte, als gehäuselose Halbleiter-Chips ausgebildete HF-Transistoren. Zweckmäßig dabei ist, daß die Halbleiter, die nicht hermetisch dicht gekoppelt sind, durch geeignete Verfahren, z.B. durch Passivierung mit geeigneten Überzügen, wirksam gegenüber Umwalteinflüssen geschützt sind. Im Hinblick auf eine einfache Handhabung des Trägers 34 ist die Oberseite mit einer Schutzkappe 37 abgedeckt.

Bei dem Breitbandverstärker werden gehäuselose Halbleiter-Chips verwendet, die auf einer gemeinsamen Trägerplatte angeordnet sind.

Der auf dem aktiven Teil 3 befindliche Träger 34 für die Halbleiter-Chips ist ein kleines Plättchen, insbesondere aus Aluminiumoxyd-Keramik oder Berylliumoxyd-Keramik. Er besitzt auf der Rückseite einen als Kühlbolzen ausgebildeten Kühlkörper 36, über den die Verlustwärme der Transistoren 310, 320, 330 abgeführt wird. Die Vorderseite des Trägers 34 trägt eine strukturierte Metallisierung in Form von aufgedruckten Dickschichtleiterbahnen, auf der die Halbleiter mit ihren Kollektoren auflegiert sind. Die übrigen Elektroden sind über Drähte kontaktiert. Der Träger 34 wird über metallische Bändchen mit der Schichtschaltung leitend verbunden. Es kann sich aber auch eine direkte Drahtkontaktierung von den Halbleiter-Chips zur Schichtschaltung als zweckmäßig erweisen.

Durch den Fortfall von Einzelgehäusen, deren Abmessungen aus technischen Gründen im allgemeinen ein Vielfaches der Chipabmessungen betragen, können die Halbleiter der einzelnen Verstärkerstufen in vorteilhafter Weise wesentlich enger zueinander angeordnet werden. Durch die eng benachbarte Anordnung der Transistoren 310, 320, 330 reduziert sich der Faktor $l_{GK}$ in Gleichung (4).

Zusätzlich verringert sich auch die elektronische Laufzeit $t_{02}$, die bei einer Emitterschaltung vorwiegend durch die Emitterinduktivität beeinfluß wird. Die Verringerung der Emitterinduktivitäten und der parasitären Kapazitäten zwischen Transistoreingang und -ausgang haben daher einen wesentlichen Einfluß.

Durch die Kombination der getroffenen Maßnahmen ergibt sich eine besonders geringe Signallaufzeit im Gegenkopplungsweg. Dadurch ist es in vorteilhafter Weise möglich, das Gegenkopplungsmaß des Breitbandverstärkers wesentlich anzuheben, ohne die Reserven gegen Selbsterregung zu verringern bzw. Fertigung oder Prüfung zu erschweren.

7 Patentansprüche
6 Figuren

Patentansprüche

1. Breitbandverstärker, vorzugsweise Leitungsverstärker der Trägerfrequenztechnik, mit einem eine Kettenschaltung von drei Transistorstufen enthaltenden Verstärkerteil und einem zwischen dem Ausgang und dem Eingang des Verstärkerteiles angeordneten Gegenkopplungsteil, wobei die in der Kettenschaltung erste und die letzte Transistorstufe als Emitterstufe geschaltet sind, d a - d u r c h   g e k e n n z e i c h n e t , daß die zwischen den Emitterstufen (31,33) gelegene Transistorstufe (32) in Kollektorschaltung geschaltet ist, und daß der Gegenkopplungsteil zwischen dem Kollektor des Transistors (330) der letzten Verstärkerstufe und dem Emitter des Transistors (310) der ersten Transistorstufe (31) angeordnet ist, und daß die Transistoren als gehäuselose Halbleiter ausgebildet und auf einem gemeinsamen Träger (34) angeordnet sind, und daß dem Träger (34) benachbart der Gegenkopplungsteil (4) angeordnet ist, und daß der Eingangsübertrager (2) und der Ausgangsübertrager (5) auf einer einen hochfrequenzwirksamen Teil des Verstärkers enthaltenden Schichtschaltung (35) angeordnet sind.

2. Breitbandverstärker nach Anspruch 1, d a d u r c h   g e k e n n z e i c h n e t , daß der Träger (34) in oder auf das Substrat (35) des Schichtschaltungsteiles einsetzbar bzw. aufsetzbar ist.

3. Breitbandverstärker nach Anspruch 1 oder 2, d a - d u r c h   g e k e n n z e i c h n e t , daß der Träger (34) als Trägerplatte ausgebildet ist, die auf der einen Seite die Transistoren (310,320,330) und auf der anderen Seite einen dem Transistor (330) der Endstufe (33) gegenüber angeordneten Kühlkörper (36) trägt.

0003138

4. Breitbandverstärker nach einem der Ansprüche 1 bis 3, d a d u r c h   g e k e n n z e i c h n e t , daß der Verstärkerteil (3) und der Gegenkopplungsteil (4) als getrennte Schichtschaltungen ausgebildet sind, die durch einen schmalen Luftspalt (6) getrennt sind.

5. Breitbandverstärker nach einem der Ansprüche 1 bis 4, d a d u r c h   g e k e n n z e i c h n e t , daß der Verstärkerteil (3) und der Gegenkopplungsteil (4) als eine gemeinsame Schichtschaltung ausgebildet sind.

6. Breitbandverstärker nach den Ansprüchen 2 und 3, d a d u r c h   g e k e n n z e i c h n e t , daß der Schichtschaltungsteil (35) mit einer Öffnung (350) versehen ist, durch die der Kühlkörper (36) hindurchgreift.

7. Breitbandverstärker nach einem der Ansprüche 1 bis 6, d a d u r c h   g e k e n n z e i c h n e t , daß der Eingangsübertrager (2) und der Ausgangsübertrager (5) als Schalenkernübertrager mit einer Folienstapel-Wicklung ausgebildet sind.

# Fig.1

Fig. 2

Fig. 3

$10^{-9}s$

0,25

0,2

0,15

$t_{02}$ 0,1

0,05

0

2   4   6   8   10   nH

L

Fig. 4

3

34

2

35

5

6

4

Fig. 5

320

310

330

35

Fig. 6

34

310

330

320

36

350

37

35

0003138

| Europäisches Patentamt | EUROPÄISCHER RECHERCHENBERICHT | Nummer der Anmeldung EP 79 10 0093 |

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE - A - 2 533 889 (STANDARD ELECTRIC LORENTZ) <br> * Seite 3, Absatz 2 * <br> -- | 1 |
| | ARCHIV DER ELEKTRISCHEN UEBER-TRAGUNG, Band 21, Nr. 9, September 1967, Stuttgart, DE, H. SINNREICH "Frequenzabhängiger Klirrfaktor und Intermodulation zweiter Ordnung in gegen-gekoppelten Transistorverstärkern" Seiten 493-496 <br> * Seite 495, unter Nummer 4, Ab-sätze 1,2; Figur 3 * <br> -- | 1 |
| | DE - B - 1 043 432 (SIEMENS) <br> * Spalte 2, Zeile 52 bis Spalte 3, Zeile 6 * <br> -- | 1,3 |
| | FR - A - 2 303 443 (HUGHES) <br> * Seite 5, Zeile 2 bis Seite 6, Zeile 22 * <br> & GB - A - 1 504 663 (Veröf. 22. März 1978) <br> -- | 1-3 |
| P | FREQUENZ, Band 32, Nr. 6, Juni 1978, Berlin, DE, BRAUN UND KOPPEHELE "Eine neue Generation von 60 MHz - Verstär-kern für den Nachrichtenverkehr über Koaxialkabel", Seiten 160-164 <br> ./. | 1-7 |

**KLASSIFIKATION DER ANMELDUNG (Int.Cl.²)**

H 03 F 1/34
H 04 B 3/36

**RECHERCHIERTE SACHGEBIETE (Int. Cl.²)**

H 03 F
H 04 B
H 05 K
H 01 L

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patent-familie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 05-04-1979 | THOMAES |

EPA form 1503.1  06.78

| | Europäisches Patentamt | **EUROPÄISCHER RECHERCHENBERICHT** |
|---|---|---|

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | * Vollständiger Artikel * | |
| P | THE TRANSACTIONS OF THE IECE OF JAPAN, Band E61, Nr. 5, Mai 1978, Tokio, Japan, S. MANO et al: "The optimum circuit configuration of a wideband hybrid feedback amplifier", Seiten 397-398 <br> * Figur 1 "E + C + E type" * | 1 |

**KLASSIFIKATION DER ANMELDUNG (Int.Cl.²)**

**RECHERCHIERTE SACHGEBIETE (Int. Cl.²)**